(19)

Europäisches
Patentamt
European
Patent Office
Office européen
des brevets

(11) **EP 3 016 471 A1**

(12) **EUROPEAN PATENT APPLICATION**
published in accordance with Art. 153(4) EPC

(43) Date of publication:
**04.05.2016 Bulletin 2016/18**

(21) Application number: **13887881.4**

(22) Date of filing: **16.08.2013**

(51) Int Cl.:
*H04W 88/02* (2009.01)          *H04B 1/40* (2006.01)
*G06F 1/18* (2006.01)          *G06F 13/14* (2006.01)

(86) International application number:
**PCT/CN2013/081637**

(87) International publication number:
**WO 2014/205902 (31.12.2014 Gazette 2014/53)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **26.06.2013   CN 201310258343**

(71) Applicant: **Huizhou TCL Mobile Communication Co., Ltd.**
**Huizhou, Guangdong 516006 (CN)**

(72) Inventors:
• **ZHAO, Shiqing**
**Huizhou**
**Guangdong 516006 (CN)**

• **LUO, Dexiang Edward**
**Huizhou**
**Guangdong 516006 (CN)**
• **HU, Xuelong Ronald**
**Huizhou**
**Guangdong 516006 (CN)**

(74) Representative: **Brachmann, Roland W.**
**Von Lieres Brachmann Schulze**
**Patentanwälte**
**Grillparzerstrasse 12A**
**81675 München (DE)**

(54) **COMMUNICATION MODULE AND CORRESPONDING PORTABLE TERMINAL**

(57)    Disclosed are a communication module and a corresponding portable terminal, wherein the communication module comprises: an NGFF interface; a switch unit, used for controlling the connection and disconnection of the power supply of a power supply end of the communication module and a power source pin of the NGFF interface; a charging protection unit, used for charging when the switch unit turns off, and also used for eliminating an impulse current at the moment when the switch unit turns on; and a time delay unit, used for controlling that the switch unit turns on with a time delay. The present invention can guarantee the integrity and stability of data.

Figure 2

EP 3 016 471 A1

**Description**

Technical Field

The present invention relates to communication technologies. In particular, it relates to a communication module and the corresponding portable terminal.

Background Art

The current communication modules are usually 3G (3rd Generation, the third generation mobile communication technology) module and 4G (4th Generation, the fourth generation mobile communication technology) module, which are generally assembled in the smart terminals, such as mobile phone and tablet computer and so on. When connected to internal control system, connection to network can be achieved. The size and interface mode of the 3G/ 4G module will directly affect the size and connection mode of the smart terminal which has been assembled with the 3G/ 4G module. In particular, portable smart terminals have even high requirements for the size and interface of the 3G/ 4G module.

However, the currently available 3G/ 4G module usually adopts the Mini-PCIe (Mini Peripheral Component Interconnect Express) interface. Such interface has a relatively large volume, and thus cannot meet the requirement of the current portable smart terminals. In addition, when in use, the 3G/ 4G module generally needs to be hot plugged in and unplugged from Mini-PCIe connector in the terminal. That is to say, plug or unplug when the power is still on, which allows users to remove or replace the 3G/ 4G module without shutting down the system and without turning off the power. In such mode, only a simply action of plugging or unplugging is necessary for removing the 3G/ 4G module; while the system keeps running without interruption, thereby it has improved the system's capability for timely recovery from a disaster, as well as its extendibility and flexibility.

However, during hot plugging and unplugging, the current 3G/ 4G module has the problems set forth below:

1. USB (Universal Serial BUS) interface data corruption. With respect to the design of PCB (Printed Circuit Board) of the current 3G/ 4G module, the lengths of all signal and data pins are the same, such as the length of USB data interface's D+ (positive data) pin and D- (negative data) pin and the length of its power supply pin are the same. In this regard, when the 3G/ 4G module is pulling out, its USB communication and data transmissions are disconnected at the same time. While at that time point, the data may still be under transmission. Accordingly, the host system may not have enough time to save the data, which may result in partial data loss.

2. Power interface generating large instantaneous current. When the 3G/ 4G module is being plugged in, the power supply voltage in the host system will be immediately applied to the power supply end of the 3G/ 4G module, so as to generate a large instantaneous current. The large current may burn some elements in the power module of the 3G/ 4G module, and further lead to malfunction or even crash of the system.

Summary of Invention

In view of the deficiencies in the existing technologies, one object of the present invention is to provide a communication module and the corresponding portable terminal, in order to solve the problems associated with the current available communication modules, such as quite big volume, as well as that during hot plugging and unplugging, the potential occurrences of data loss and large instantaneous current, which may hurt the system's stability.

In order to achieve the above mentioned object, the present invention has employed the technical solution set forth below:

A communication module, comprising: an NGFF interface having power supply pins; as well as universal serial bus (USB) data transmission pins; wherein, a length of the universal serial bus (USB) data transmission pins is shorter than that of the power supply pins; a switch unit, for controlling connection and disconnection of power supply between a power supply end of the communication module and the power supply pins; a charge protection unit, for making power charge when the switch unit is turned off, and
for eliminating an impact current generated at the instant when the switch unit is turning on; and a delay unit, for controlling the switch unit's delay turning on; wherein, the switch unit, the charge protection unit and the delay unit are connected to the power supply pins of the NGFF interface, the switch unit is connected to the power supply end through the charge protection unit; the switch unit being a metal oxide semiconductor;
wherein, a source electrode of the metal oxide semiconductor is connected to the power supply pins of the NGFF interface, a first input end of the charge protection unit, and a first end of the delay unit, a gate electrode of the metal oxide semiconductor is connected to a second end of the delay unit, a drain electrode of the metal oxide semiconductor is connected to a second input end of the charge protection unit; wherein,

the length of the universal serial bus (USB) data transmission pins is longer than or equal to two thirds of the length of the power supply pins - 0.1 mm, and is shorter than or equal to two thirds of the length of the power supply pins + 0.1 mm; the communication module also comprising a printed circuit board (PCB); wherein, the printed circuit board is provided with an electronic components layout area, and a shield covering the electronic components layout area.

In the communication module mentioned above, the charge protection unit comprises: a first resistor; a first capacitor; and a second capacitor; wherein, a first connection end of the first resistor is connected to the source electrode of the metal oxide semiconductor, the power supply pins of the NGFF interface and the first end of the delay unit, a second connection end of the first resistor is connected to the drain electrode of the metal oxide semiconductor, one end of the first capacitor, a positive electrode of the second capacitor and the power supply end of the communication module; wherein, both the other end of the first capacitor and the negative electrode of the second capacitor are grounded; the delay unit comprising: a second resistor; and a third capacitor; wherein, a third connection end of the second resistor is connected to the gate electrode of the metal oxide semiconductor, in addition, via the third capacitor, the third connection end of the second resistor is also connected to the first connection end of the first resistor, the source electrode of the metal oxide semiconductor and the power supply pins of the NGFF interface, a fourth connection end of the second resistor is grounded.

In the communication module mentioned above, the NGFF interface comprises: at least one radio frequency (RF) pin; and at least two ground pins; wherein, the ground pins are arranged at two sides of the radio frequency (RF) pin; wherein, for each the radio frequency (RF) pin, there are two ground pins being arranged at each of the two sides of the radio frequency (RF) pin.

A communication module, comprises: an NGFF interface having power supply pins; as well as universal serial bus (USB) data transmission pins; wherein, a length of the universal serial bus (USB) data transmission pins is shorter than that of the power supply pins; a switch unit, for controlling connection and disconnection of power supply between a power supply end of the communication module and the power supply pins; a charge protection unit, for making power charge when the switch unit is turned off, and for eliminating an impact current generated at the instant when the switch unit is turning on; and a delay unit, for controlling the switch unit's delay turning on; wherein, the switch unit, the charge protection unit and the delay unit are connected to the power supply pins of the NGFF interface, the switch unit is connected to the power supply end through the charge protection unit.

In the communication module mentioned above, the switch unit is a metal oxide semiconductor; wherein, a source electrode of the metal oxide semiconductor is connected to the power supply pins of the NGFF interface, a first input end of the charge protection unit, and a first end of the delay unit, a gate electrode of the metal oxide semiconductor is connected to a second end of the delay unit, a drain electrode of the metal oxide semiconductor is connected to a second input end of the charge protection unit.

In the communication module mentioned above, the charge protection unit comprises: a first resistor; a first capacitor; and a second capacitor; wherein, a first connection end of the first resistor is connected to the source electrode of the metal oxide semiconductor, the power supply pins of the NGFF interface and the first end of the delay unit, a second connection end of the first resistor is connected to the drain electrode of the metal oxide semiconductor, one end of the first capacitor, a positive electrode of the second capacitor and the power supply end of the communication module; wherein, both the other end of the first capacitor and the negative electrode of the second capacitor are grounded.

In the communication module mentioned above, the delay unit comprises: a second resistor; and a third capacitor; wherein, a third connection end of the second resistor is connected to the gate electrode of the metal oxide semiconductor, in addition, via the third capacitor, the third connection end of the second resistor is also connected to the first connection end of the first resistor, the source electrode of the metal oxide semiconductor and the power supply pins of the NGFF interface, a fourth connection end of the second resistor is grounded.

In the communication module mentioned above, the NGFF interface comprises: at least one radio frequency (RF) pin; and at least two ground pins; wherein, the ground pins are arranged at two sides of the radio frequency (RF) pin.

In the communication module mentioned above, for each the radio frequency (RF) pin, there are two ground pins being arranged at each of the two sides of the radio frequency (RF) pin.

In the communication module mentioned above, the length of the universal serial bus (USB) data transmission pins is longer than or equal to two thirds of the length of the power supply pins - 0.1 mm, and is shorter than or equal to two thirds of the length of the power supply pins + 0.1 mm.

In the communication module mentioned above, the communication module also comprises a printed circuit board (PCB); wherein, the printed circuit board is provided with an electronic components layout area, and a shield covering the electronic components layout area.

A portable terminal, comprising a control system, wherein the portable terminal also comprising a communication module, the communication module is connected to the control system, the communication module comprising: an NGFF interface having power supply pins; as well as universal serial bus (USB) data transmission pins; wherein, a length of the universal serial bus (USB) data transmission pins is shorter than that of the power supply pins; a switch unit, for controlling connection and disconnection of power supply between a power supply end of the communication module and the power supply pins; a charge protection unit, for making power charge when the switch unit is turned off, and for eliminating an impact current generated at the instant when the switch unit is turning on; and a delay unit, for controlling the switch unit's delay turning on; wherein, the switch unit, the charge protection unit and the delay unit are connected to the power supply pins of the NGFF interface, the switch unit is connected to the power supply end through the charge protection unit.

In the portable terminal mentioned above, the switch unit is a metal oxide semiconductor; wherein, a source electrode of the metal oxide semiconductor is connected to the power supply pins of the NGFF interface, a first input end of the charge protection unit, and a first end of the delay unit, a gate electrode of the metal oxide semiconductor is connected to a second end of the delay unit, a drain electrode of the metal oxide semiconductor is connected to a second input end of the charge protection unit.

In the portable terminal mentioned above, the charge protection unit comprises: a first resistor; a first capacitor; and a second capacitor; wherein, a first connection end of the first resistor is connected to the source electrode of the metal oxide semiconductor, the power supply pins of the NGFF interface and the first end of the delay unit, a second connection end of the first resistor is connected to the drain electrode of the metal oxide semiconductor, one end of the first capacitor, a positive electrode of the second capacitor and the power supply end of the communication module; wherein, both the other end of the first capacitor and the negative electrode of the second capacitor are grounded.

In the portable terminal mentioned above, the delay unit comprises: a second resistor; and a third capacitor; wherein, a third connection end of the second resistor is connected to the gate electrode of the metal oxide semiconductor, in addition, via the third capacitor, the third connection end of the second resistor is also connected to the first connection end of the first resistor, the source electrode of the metal oxide semiconductor and the power supply pins of the NGFF interface, a fourth connection end of the second resistor is grounded.

In the portable terminal mentioned above, the NGFF interface comprises: at least one radio frequency (RF) pin; and at least two ground pins; wherein, the ground pins are arranged at two sides of the radio frequency (RF) pin.

In the portable terminal mentioned above, for each the radio frequency (RF) pin, there are two ground pins being arranged at each of the two sides of the radio frequency (RF) pin.

In the portable terminal mentioned above, the length of the universal serial bus (USB) data transmission pins is longer than or equal to two thirds of the length of the power supply pins - 0.1 mm, and is shorter than or equal to two thirds of the length of the power supply pins + 0.1 mm.

In the portable terminal mentioned above, the communication module also comprises a printed circuit board (PCB); wherein, the printed circuit board is provided with an electronic components layout area, and a shield covering the electronic components layout area.

In the portable terminal mentioned above, the communication module also comprises power elements or structural elements, the power elements or the structural elements are arranged in the control system, and are connected to the printed circuit board (PCB) of the communication module through the NGFF interface.

In comparison with the existing technologies, with providing an NGFF interface in the communication module, which helps to reduce the volume of the communication module, the communication module and the corresponding portable terminal provided in the present invention are able to reduce the structural limitation for the assembly of the communication module and the portable terminal. In addition, with the configuration that the length of the universal serial bus (USB) data transmission pins is shorter than that of the power supply pins, it allows the portable terminal to save the USB data in advance or get the power ready, and then perform USB disconnection or start to communicate, respectively. In this way, it ensures the integrity and stability of data. In addition, when the communication module is being plugged in, due to the precharge with small current performed by the charge protection unit, the impact current, which may be generated at the instant when the switch unit is turning on, is eliminated, which protects the switch unit from being damaged by the large instantaneous current which would be generated at such moment. Therefore, it has improved the stability and reliability of the system.

Description of Drawings

Figure 1    is a block diagram of the structural mechanism of the communication module provided in the present invention.

Figure 2    is a main structural view of the communication module provided in the present invention.

Figure 3    is a rear structural view of the communication module provided in the present invention.

Figure 4    is an enlarged schematic view of the part A shown in the Figure 2.

Figure 5    is a circuit diagram of the communication module provided in the present invention.

Description of Embodiments

The present invention provides a communication module and the corresponding portable terminal. In order to make the aim, technical solution and technical effect of the present invention become clear and definite, the present invention will be further described in details, in reference to the accompanying drawings and exemplary embodiments. It should be understood that the specific embodiments set forth below are only for the purpose of describing the present invention, not for limiting the present invention.

The communication module provided in the present invention is 3G module, 4G module, etc, which would be inserted into a smart terminal (namely the portable terminal, such as mobile phone, tablet computer and so on) and other portable terminals, so as to achieve network connection. The communication module utilizes small size NGFF (Next Generation Form Factor) interface, and the corresponding NGFF connector has been provided in the portable terminal. The communication module not only has the feature of being compatible with standard NGFF interface, but also has significantly smaller volume, as well as is able to meet the requirement of hot plugging and unplugging. Therefore, it is able to fully meet the requirements for 4G and 3G modules from the future smart terminal and other devices.

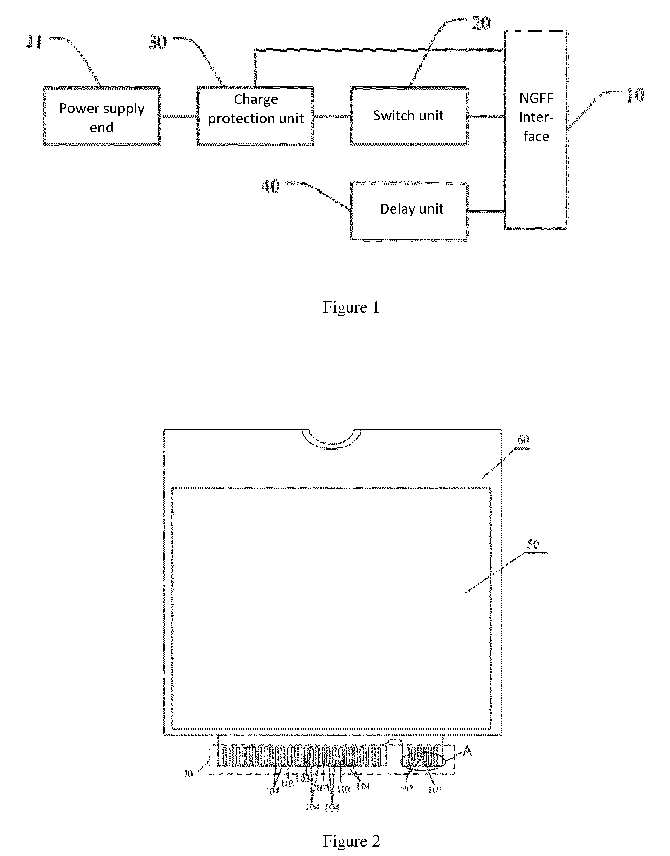

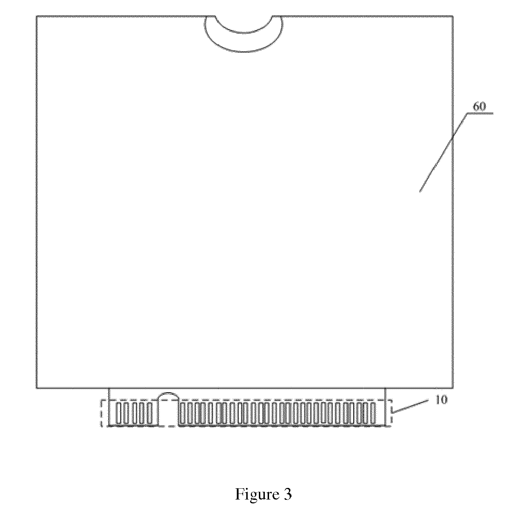

In reference to Figure 1, Figure 2 and Figure 3, wherein, Figure 1 is a block diagram of the structural mechanism of the communication module provided in the present invention. Figure 2 is a main structural view of the communication module provided in the present invention. Figure 3 is a rear structural view of the communication module provided in the present invention.

As shown in Figures 1 to 3, the communication module provided in the present invention comprises PCB board 60, NGFF (Next Generation Form Factor) interface 10, switch unit 20, charge protection unit 30 and delay unit 40; wherein, the NGFF interface 10 is the new generation interface standard tailored by Intel for ultra-books. It allows the size of communication module to be 42 mm x 22 mm, thickness with single side element layout as 2.75 mm, and thickness with double side element layout as 3.85 mm. As a result, the size of the NGFF interface 10 is smaller than that of the current Mini-PCIe interface, which renders the communication module the features such as small size, interface standardization and supporting hot plugging and unplugging.

More specifically, the NGFF interface 10, switch unit 20, charge protection unit 30 and delay unit 40 are all arranged on the PCB board 60. The NGFF interface 10 is an interface with connecting finger, and is located at one end of the PCB board 60. It allows the communication module to be plugged into the portable terminal (such as mobile phone, tablet computer and other types of terminal) through this NGFF interface 10, and then connected to the control system in it (in other words, connected to the control circuit in the portable terminal), thus achieve connection to a network.

The NGFF interface 10 comprises power supply pin 101 and universal serial bus (USB) data transmission pin 102. The switch unit 20, charge protection unit 30 and delay unit 40 are respectively connected to the power supply pin 101 of the NGFF interface 10. The switch unit 20 is connected to the power supply end J1 of the communication module through the charge protection unit 30. Wherein, the switch unit 20 is for controlling the connection and disconnection of power supply between the power supply end J1 of the communication module and the power supply pins 101. The charge protection unit 30 is for making power charge when the switch unit 20 is turned off, and for eliminating an impact current generated at the instant when the switch unit 20 is turning on. The delay unit 40 is for controlling the switch unit 20's delay turning on. The delay unit 40 controls the delay turning on of the switch unit 20. In addition, within pre-determined delay time period (i.e., during the time period when the switch unit 20 is off), by virtue of the charge protection unit 30, a small current charging has been performed, which works to eliminate the impact current generated when the switch unit 20 is turned on, thus prevent the switch unit 20 from being damaged. It should be noted that in the present invention, only the switch unit 20, the charge protection unit 30, and the delay unit 40 have been added to the communication module, all other module components in the communication module are the same as those in the existing technologies; and thus they won't be described in details here.

In reference to Figure 2, Figure 3 and Figure 4, the USB data transmission pin 102 of the NGFF interface 10 comprises positive data transmission pin D+ and the negative data transmission pin D-. In order to avoid data loss or saving failure during hot plugging or unplugging, the USB data transmission pin 102 is shorter than the power supply pin 101. That is to say, the length of the USB data transmission pin is shorter than that of the power supply pin. In the present invention, it could be understood as that the USB data transmission pin 102 is shorter than other pins (including the power supply pin 101) on the same NGFF interface 10. When designing the PCB board 60 of the communication module, the USB data transmission pin 102 is arranged at the front side of the PCB board 60. All other pins on the same front side and on the back side of the PCB board 60 may maintain the normal pin length of the standard NGFF interface 10.

In one embodiment of the present invention, the length of the universal serial bus (USB) data transmission pin 102 is two thirds of the length of the power supply pin 101 $\pm$ 0.1 mm. In order words, the length of the universal serial bus (USB) data transmission pins is longer than or equal to two thirds of the length of the power supply pins-0.1 mm, and is shorter than or equal to two thirds of the length of the power supply pins + 0.1 mm. When the communication module is plugging in, firstly the power supply pin 101 is connected to the power supply pin of the device in which it is plugged to, such that the entire system is powered on and starts to work, next the positive data transmission pin D+ and negative data transmission pin D- are respectively connected to the positive data transmission pin D+ and negative data transmission pin D- on the NGFF connector, so as to start USB communication. In this way, the CPU (Central Processing Unit) of the portable terminal is able to power on the communication module in advance; and then when the system becomes stable; it would be ready to wait for the USB data transmission.

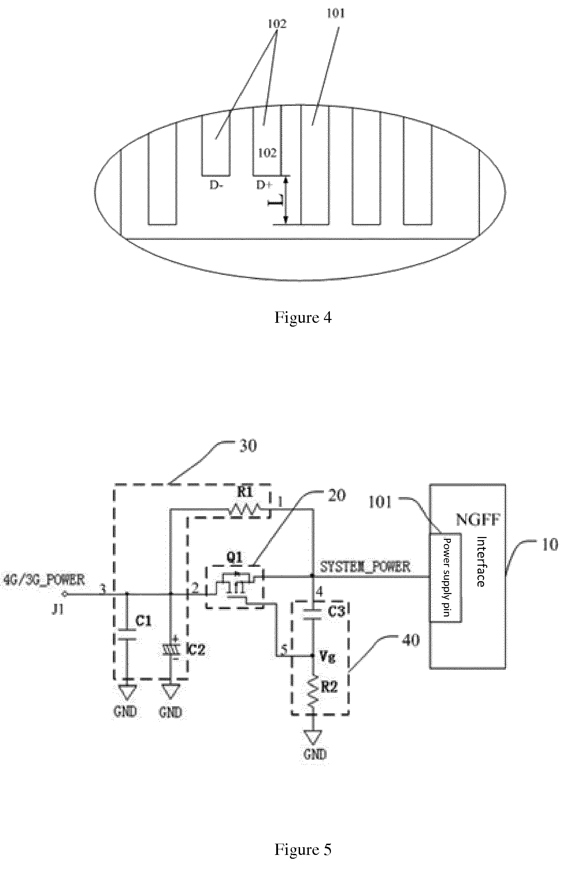

When the communication module is unplugged, firstly the positive data transmission pin D+ and negative data transmission pin D- are disconnected. That is to say, the USB communication is disconnected first. At this moment, the CPU is able to treat the USB disconnection event and save related data. Next, the power supply pin 101 of the communication module is disconnected from the power supply pin on the NGFF connector, which would be to power off the communication module. In practice, the lengths of the positive data transmission pin D+ and the negative data transmission pin D- are shorter than that of other pins (including the power supply pin 101) by L; and the L is preferably 0.5 mm, as shown in Figure 4. Such length difference may vary according to different plugging and unplugging speed. The time when the power supply pin 101 is disconnected is delayed about a few hundred ms (millisecond) than the time when the USB data transmission pin 102 is disconnected. As a result, there would be a time period of a few hundred ms existing after the USB data transmission pin 102 is disconnected from the NGFF connector and before the power supply pin 101 is disconnected from the power supply pin on the NGFF connector. Within this time period, CPU would have sufficient time to handle the USB disconnection event as well as save the related data. Therefore, before the communication module is powered off, CPU has already saved all the data and stopped data transmission. In this way, the problems in the existing technologies such as data loss and saving failure resulted from that the power off and data transmission disconnection occur at the same time, have been avoided. Accordingly, it has greatly improved the integrity and accuracy of data.

In order to avoid the generation of a large instantaneous current at the NGFF connector of the smart terminal, when the communication module is plugged in, the present invention employs the switch unit 20 to disconnect the power supply connection between the power supply end J1 of the communication module and the power supply pin 101, which prevents the communication module from the impact of the large instantaneous current. When the large instantaneous current disappears, the switch unit 20 will further control to connect the power supply between the power supply end J1 of the communication module and the power supply pin 101.

In reference to Figure 1 and Figure 5, the switch unit 20 is the MOS (Metal Oxide Semiconductor) tube Q1. The source electrode of the MOS tube Q1 is connected to the power supply pin 101 of the NGFF interface 10, the first input end 1 of the charge protection unit 30, and the first end 4 of the delay unit 40. The gate electrode of the MOS tube Q1 is connected to the second end 5 of the delay unit 40. The drain electrode of the MOS tube Q1 is connected to the second input end 2 of the charge protection unit 30. In addition, the output end 3 of the charge protection unit 30 is connected to the power supply end J1 of the communication module.

The system power SYSTEM_POWER provided by the power supply pin of the control system's NGFF connector is applied, via the power supply 101 of the NGFF interface 10, to the source electrode of the MOS tube Q1, the first input end 1 of the charge protection unit 30 and the first end 4 of the delay unit 40. In practice, the MOS tube Q1 is a PMOS (Positive channel Metal Oxide Semiconductor) tube. When the gate electrode is inputted with a low electrical level, the MOS tube Q1 become open; while when the gate electrode is inputted with a high electrical level, the MOS tube Q1 is shut off.

The charge protection unit 30 is for performing small current charging when the switch unit 20 is turned off, so as to eliminate the impact current generated at the moment when the switch unit 20 is turned on. In addition, through such charging, the voltage of the power supply end J1 of the communication module increases, when the voltage at the power supply end J1 4G/ 3G _Power is equal or close to the voltage of the system power SYSTEM_POWER, the MOS tube Q1 is open. In such case, the impact current generated at the switch unit is the smallest, and thus has the minimal impact on system power supply.

In this embodiment, the charge protection unit 30 comprises the first resistor R1; the first capacitor C1 and the second capacitor C2. One end (first connection end) of the first resistor R1 is connected to the source electrode of the MOS tube Q1, the power supply pin 101 of the NGFF interface 10 and the first end 4 of the delay unit 40. The other end (second connection end) of the first resistor R1 is connected to the drain electrode of the MOS tube Q1, one end of the first capacitor C1, the positive electrode of the second capacitor C2 and the power supply end J1 of the communication module. In addition, both the other end of the first capacitor C1 and the negative electrode of the second capacitor C2 are grounded. In order to control the charging current and charging time of the charge protection unit 30, the resistance of the first resistor R1 is preferably 20 $\Omega$. The first capacitor C1 is a filter capacitor, for filtering out high frequency and pulse interferences. Its capacitance is 100 pF. The second capacitor C2 is a large capacitor, for charging and controlling pulse power consumption within a suitable range. Its capacitance is 150 pF.

The delay unit 40 is for controlling the delayed open time of the MOS tube Q1. More specifically, it includes: the second resistor R2; and the third capacitor C3. One end (third connection end) of the second resistor R2 is connected to the gate electrode of the metal oxide semiconductor MOS tube Q1. In addition, via the third capacitor C3, the one end (third connection end) the second resistor R2 is also connected to one end (first connection end) of the first resistor R1, the source electrode of the MOS tube Q1, and the power supply pin 101 of the NGFF interface 10. The other end (fourth connection end) of the second resistor R2 is grounded; wherein, the voltage at the connection point between the second resistor R2 and the third capacitor C3 is Vg.

It is noted that, the respective values of the first resistor R1, the second resistor R2, the second capacitor C2, the third capacitor C3 should meet the requirements set forth below: the time constant between the first resistor R1 and the second capacitor C2 is smaller than the time constant between the second resistor R2 and the third capacitor C3. That is to say, after the second capacitor C2 has been fully charged and the power supply voltage 4G/ 3G_Power of the communication module is equal or close to the system power SYSTEM_POWER, the third capacitor C3 then finish its negative charging, i.e., the voltage Vg drops to the threshold voltage of the MOS tube Q1. This is because when the power supply voltage 4G/ 3G_Power is equal to or close to the system power SYSTEM_POWER, the current flows from the system power SYSTEM_POWER to the power supply voltage 4G/ 3G_Power is very small. In such case, when the MOS tube Q1 is open, it could avoid the generation of a large instantaneous current which would have occurred during plugging when the SYSTEM_POWER of a certain voltage is transferred to the 4G/ 3G_POWER of 0 V. In this way, the impact of the instantaneous current to the MOS tube Q1 would be very small. Accordingly, the elements in the power module of the communication module won't be burned, and its influence on the communication module's power is reduced, too. In this regard, based on the values of the first resistor R1 and the second capacitor C2, the resistance of the second resistor R2 is accordingly set as 220 K, and the capacitance of the third capacitor C3 is accordingly set as 1 uF.

Using the communication module, 4G/ 3G module, being plugged in a tablet computer as an example, and in reference to Figure 5, the process of avoiding and limiting the large current generated during the communication module plugging will be described in details as follows:

The system power of the tablet computer SYSTEM_POWER is connected to the source electrode of the MOS tube Q1 of the 4G/ 3G module through the NGFF interface 10. The MOS tube Q1 functions as the switch of the power supply of the 4G/ 3G module. At the moment when the 4G/ 3G module is just connected to the system power SYSTEM_POWER, due to the property of capacitor, the voltage between the two ends of the third capacitor C3 is free of a sudden change, when the 4G/ 3G module is just connected to the system power, Vg, the voltage at the connection point between the third capacitor C3 and the second resistor R2, is SYSTEM_POWER. That is to say, the voltage of the gate electrode of the MOS tube Q1 is the SYSTEM_POWER. At this moment, both the voltage of the gate electrode and the voltage of the source electrode are SYSTEM_POWER, and the MOS tube Q1 is in a cut off state. Moreover, during this time period, the system power SYSTEM_POWER performs small current charging to the first capacitor C1 and the second capacitor C2, through the first resistor R1, and the charging current is (SYSTEM_POWER - 4G/ 3G_POWER) / R1. When the voltage Vg drops to the value equal to the switch threshold voltage of the MOS tube Q1, the MOS tube Q1 is open, since the internal resistance in the MOS tube Q1 is very small and thus is negligible, the power supply end J1 of the communication module could be considered as the power supply pin directly connected to the system power SYSTEM_POWER. In other words, the voltage of 4G/ 3G_POWER is equal or close to the voltage of SYSTEM_POWER. Accordingly, the time delay constant t of the MOS tube Q1 can be determined through adjusting the values of the second resistor R2 and the third capacitor C3,

$$t = R2 \times C3 \times \ln((SYSTEM\_POWER - Vg) / SYSTEM\_POWER),$$

so as to make, when the MOS tube Q1 is open, the voltage of 4G/ 3G_POWER is equal or close to the voltage of SYSTEM_POWER. In this case, the switch impact current is the smallest, which has the smallest impact to the system power.

In the present invention, the radio frequency (RF) pin 103 of the NGFF interface 10 has been undergone corresponding treatment, so as to reduce radio frequency signal attenuation. In reference to Figure 2 and Figure 3, the NGFF interface 10 also comprises at least one radio frequency (RF) pin 103; and at least two ground pins 104. The ground pins 104 are arranged at two sides of the radio frequency (RF) pin 103. The radio frequency (RF) pin 103 is provided on the front side of the PCB board 60. As shown in Figure 2, for each the radio frequency (RF) pin 103, there are two ground pins 104 being respectively arranged at the left and right sides of the radio frequency (RF) pin.

In the present invention, the terminal of the NGFF interface 10 is quite small. Accordingly, its distributed capacitance, distributed inductance and other parameters are also small. Thus, it has relatively small impact on radio frequency signal. In addition, the pins for the NGFF interface 10 are gold plated or treated with chemical gold deposition, and thus have small attenuation for radio frequency signal. Moreover, in the present invention, the ground pins are arranges at two sides of the radio frequency (RF) pin, thus they also play a role for shielding and protecting the radio frequency signal.

In practice, the USB data transmission pin 102 is USB 2.0 pin with standard NGFF interface, while the radio frequency (RF) pin 103 and a portion of the ground pins 104 are USB 3.0 pin with standard NGFF interface. In order to minimize the attenuation of radio frequency signal, the quantity of the ground pins 104 is over two fold of the quantity of the radio frequency (RF) pin 103. In addition, for each the radio frequency (RF) pin, there are two ground pins being arranged at each of the two sides of the radio frequency (RF) pin. In other words, two ground pins 104 have been provided in between two radio frequency (RF) pins 103. As shown in Figure 2, for each the radio frequency (RF) pin 103, there are two ground pins 104 being arranged at each of its two sides. In this embodiment, the definitions of all other pins on the NGFF interface 10 are identical to the definitions of other pins on the standard NGFF interface 10. Please refer to the technical documents about standard NGFF interface for the definitions of all other pins. It will not be described in detail in this application.

In the embodiment of the present invention, the PCB board 60 of the communication module is provided with an electronic components layout area (not shown in the drawings). Electronic elements are arranged in this electronic components layout area. In addition, in order to reduce signal interference, a shield 50 is provided on the PCB board 60. The shield 50 is arranged to shield the electronic components layout area.

The present invention also provides a portable terminal, which comprises a control system and a communication module. The communication module comprises a NGFF interface. The communication module is plugged into the NGFF connector in the control system through its NGFF interface, so as to be connected to a network.

In an example when the communication module is a 3G module or 4G module, the communication module also comprises power elements which have relatively greater height (such as large capacitor, power components, DC/DC (power supply for DC to DC conversion) and so on) or structural elements which have relatively bigger size (such as SIM (Subscriber Identity Module) slot, SD (Secure Digital) slot, connector and so on). In the current 3G module or 4G module, these power elements and structural elements are all arranged on the PCB board of the 3G module or 4G module, which makes the communication module have a quite big volume.

The communication module of the present invention has adopted the NGFF interface with the new generation of interface standard, which has been tailored by Intel for ultra-books. It allows the size of 3G module or 4G module to be 42 mm x 22 mm. In addition, in order to reduce the thickness of the 3G module or 4G module, the above mentioned power elements and structural elements are all arranged in the control system (that is to say, the power elements and structural elements are all arranged on the PCB board of the control system), and are electrically connected to the control circuit on the PCB board of the communication module through the NGFF interface. In this way, it has achieved the accomplishment that the thickness with single side element layout is just 2.75 mm, and the thickness with double side element layout is 3.85 mm. As a result, the size of communication module has been significantly reduced.

In light of the foregoing, with respect to the existing technologies, the present invention has the beneficial effects set forth below:

1. The interface of communication module is the small sized NGFF interface, which renders the communication module the features of small size and interface standardization and so on.

2. The communication module adopts the NGFF interface disclosed in the present invention will have a size of 42 mm x 22 mm. Its thickness with single side element layout is just 2.75 mm, and the thickness with double side element layout is 3.85 mm. The elements (such as power elements, structural elements and other element whose height cannot be reduced) with relatively greater height are arranged in the control system that is located beyond of the communication module, so as to effectively reduce the thickness of the communication module.

3. In the NGFF interface, the ground pins are arranged at two sides of the radio frequency (RF) pin, so as to reduce radio frequency signal attenuation, as well as to shield and protect the radio frequency signal.

4. In the NGFF interface, the universal serial bus (USB) data transmission pin is shorter than the power supply pin. Accordingly, when the communication module is being connected to the control system, the power supply is first connected and thus the system starts to work; and next the USB data transmission pin is connected, so the USB communication is initiated. On the other hand, when the communication module is being unplugged, it is the USB data transmission pin that is disconnected first, which result in that the USB communication is disconnected first, and when the USB communication is disconnected, the control system CPU will immediately process the USB disconnection event and accordingly saves the related data. In this way, the NGFF interface supports hot plugging and unplugging. Further, with providing the communication module with the switch unit, charge protection unit and delay unit, the communication module is protected during the hot plugging and unplugging: avoid and limit the generation of large instantaneous current, when the communication module is being hot plugged or unplugged, so as to protect the power of the communication module, and prevent the power of communication module from crash.

It is understandable that based on the technical solution and inventive conception of the present invention, a person of ordinary skill in the art is able to make alternation or modification, and all these modification and alternation are within the scope claimed in the appended claims of the present application.

**Claims**

1. A communication module, comprising:

   - an NGFF interface, comprising,

     - power supply pins; and
     - universal serial bus (USB) data transmission pins;
     - wherein, a length of the universal serial bus (USB) data transmission pins is shorter than that of the power supply pins;

   - a switch unit, for controlling connection and disconnection of power supply between a power supply end of the communication module and the power supply pins;
   - a charge protection unit, for making power charge when the switch unit is turned off, and for eliminating an impact current generated at the instant when the switch unit is turning on; and
   - a delay unit, for controlling the switch unit's delay turning on;
   - wherein, the switch unit, the charge protection unit and the delay unit are connected to the power supply pins of the NGFF interface, the switch unit is connected to the power supply end through the charge protection unit;
   - the switch unit being a metal oxide semiconductor;
   - wherein, a source electrode of the metal oxide semiconductor is connected to the power supply pins of the NGFF interface, a first input end of the charge protection unit, and a first end of the delay unit, a gate electrode of the metal oxide semiconductor is connected to a second end of the delay unit, a drain electrode of the metal oxide semiconductor is connected to a second input end of the charge protection unit;
   - wherein, the length of the universal serial bus (USB) data transmission pins is longer than or equal to two thirds of the length of the power supply pins-0.1 mm, and is shorter than or equal to two thirds of the length of the power supply pins + 0.1 mm;
   - the communication module also comprising:
   - a printed circuit board (PCB);
   - wherein, the printed circuit board is provided with an electronic components layout area, and a shield covering the electronic components layout area.

2. The communication module as claimed in claim 1, wherein the charge protection unit comprises:

   - a first resistor;
   - a first capacitor; and
   - a second capacitor;
   - wherein, a first connection end of the first resistor is connected to the source electrode of the metal oxide semiconductor, the power supply pins of the NGFF interface and the first end of the delay unit, a second connection end of the first resistor is connected to the drain electrode of the metal oxide semiconductor, one end of the first capacitor, a positive electrode of the second capacitor and the power supply end of the communication module;
   - wherein, both the other end of the first capacitor and the negative electrode of the second capacitor are grounded;
   - the delay unit comprising:
   - a second resistor; and
   - a third capacitor;
   - wherein, a third connection end of the second resistor is connected to the gate electrode of the metal oxide semiconductor, in addition, via the third capacitor, the third connection end of the second resistor is also connected to the first connection end of the first resistor, the source electrode of the metal oxide semiconductor and the power supply pins of the NGFF interface, a fourth connection end of the second resistor is grounded.

3. The communication module as claimed in claim 1, wherein the NGFF interface comprises:

- at least one radio frequency (RF) pin; and
- at least two ground pins;
- wherein, the ground pins are arranged at two sides of the radio frequency (RF) pin;
- wherein, for each the radio frequency (RF) pin, there are two ground pins being arranged at each of the two sides of the radio frequency (RF) pin.

4. A communication module, comprises:

- an NGFF interface, comprising:

- power supply pins; and
- universal serial bus (USB) data transmission pins;
- wherein, a length of the universal serial bus (USB) data transmission pins is shorter than that of the power supply pins;

- a switch unit, for controlling connection and disconnection of power supply between a power supply end of the communication module and the power supply pins;
- a charge protection unit, for making power charge when the switch unit is turned off, and for eliminating an impact current generated at the instant when the switch unit is turning on; and
- a delay unit, for controlling the switch unit's delay turning on;
- wherein, the switch unit, the charge protection unit and the delay unit are connected to the power supply pins of the NGFF interface, the switch unit is connected to the power supply end through the charge protection unit.

5. The communication module as claimed in claim 4,

- wherein the switch unit is a metal oxide semiconductor;
- wherein, a source electrode of the metal oxide semiconductor is connected to the power supply pins of the NGFF interface, a first input end of the charge protection unit, and a first end of the delay unit, a gate electrode of the metal oxide semiconductor is connected to a second end of the delay unit, a drain electrode of the metal oxide semiconductor is connected to a second input end of the charge protection unit.

6. The communication module as claimed in claim 5, wherein the charge protection unit comprises:

- a first resistor;
- a first capacitor; and
- a second capacitor;
- wherein, a first connection end of the first resistor is connected to the source electrode of the metal oxide semiconductor, the power supply pins of the NGFF interface and the first end of the delay unit, a second connection end of the first resistor is connected to the drain electrode of the metal oxide semiconductor, one end of the first capacitor, a positive electrode of the second capacitor and the power supply end of the communication module;
- wherein, both the other end of the first capacitor and the negative electrode of the second capacitor are grounded.

7. The communication module as claimed in claim 6, wherein the delay unit comprises:

- a second resistor; and
- a third capacitor;
- wherein, a third connection end of the second resistor is connected to the gate electrode of the metal oxide semiconductor, in addition, via the third capacitor, the third connection end of the second resistor is also connected to the first connection end of the first resistor, the source electrode of the metal oxide semiconductor and the power supply pins of the NGFF interface, a fourth connection end of the second resistor is grounded.

8. The communication module as claimed in claim 4, wherein the NGFF interface comprises:

- at least one radio frequency (RF) pin; and
- at least two ground pins;
- wherein, the ground pins are arranged at two sides of the radio frequency (RF) pin.

9. The communication module as claimed in claim 8, wherein for each the radio frequency (RF) pin, there are two ground pins being arranged at each of the two sides of the radio frequency (RF) pin.

10. The communication module as claimed in claim 4, wherein the length of the universal serial bus (USB) data transmission pins is longer than or equal to two thirds of the length of the power supply pins - 0.1 mm, and is shorter than or equal to two thirds of the length of the power supply pins + 0.1 mm.

11. The communication module as claimed in claim 4, wherein the communication module also comprises:

- a printed circuit board (PCB);
- wherein, the printed circuit board is provided with an electronic components layout area, and a shield covering the electronic components layout area.

12. A portable terminal, comprising a control system, wherein the portable terminal also comprising a communication module, the communication module is connected to the control system, the communication module comprising:

- an NGFF interface, comprising:

- power supply pins; and
- universal serial bus (USB) data transmission pins;
- wherein, a length of the universal serial bus (USB) data transmission pins is shorter than that of the power supply pins;

- a switch unit, for controlling connection and disconnection of power supply between a power supply end of the communication module and the power supply pins;
- a charge protection unit, for making power charge when the switch unit is turned off, and for eliminating an impact current generated at the instant when the switch unit is turning on; and
- a delay unit, for controlling the switch unit's delay turning on;
- wherein, the switch unit, the charge protection unit and the delay unit are connected to the power supply pins of the NGFF interface, the switch unit is connected to the power supply end through the charge protection unit.

13. The portable terminal as claimed in claim 12,

- wherein the switch unit is a metal oxide semiconductor;
- wherein, a source electrode of the metal oxide semiconductor is connected to the power supply pins of the NGFF interface, a first input end of the charge protection unit, and a first end of the delay unit, a gate electrode of the metal oxide semiconductor is connected to a second end of the delay unit, a drain electrode of the metal oxide semiconductor is connected to a second input end of the charge protection unit.

14. The portable terminal as claimed in claim 13, wherein the charge protection unit comprises:

- a first resistor;
- a first capacitor; and
- a second capacitor;
- wherein, a first connection end of the first resistor is connected to the source electrode of the metal oxide semiconductor, the power supply pins of the NGFF interface and the first end of the delay unit, a second connection end of the first resistor is connected to the drain electrode of the metal oxide semiconductor, one end of the first capacitor, a positive electrode of the second capacitor and the power supply end of the communication module;
- wherein, both the other end of the first capacitor and the negative electrode of the second capacitor are grounded.

15. The portable terminal as claimed in claim 14, wherein the delay unit comprises:

- a second resistor; and
- a third capacitor;
- wherein, a third connection end of the second resistor is connected to the gate electrode of the metal oxide semiconductor, in addition, via the third capacitor, the third connection end of the second resistor is also connected to the first connection end of the first resistor, the source electrode of the metal oxide semiconductor and the power supply pins of the NGFF interface, a fourth connection end of the second resistor is grounded.

16. The portable terminal as claimed in claim 12, wherein the NGFF interface comprises:

- at least one radio frequency (RF) pin; and
- at least two ground pins;
- wherein, the ground pins are arranged at two sides of the radio frequency (RF) pin.

17. The portable terminal as claimed in claim 16, wherein for each the radio frequency (RF) pin, there are two ground pins being arranged at each of the two sides of the radio frequency (RF) pin.

18. The portable terminal as claimed in claim 12, wherein the length of the universal serial bus (USB) data transmission pins is longer than or equal to two thirds of the length of the power supply pins - 0.1 mm, and is shorter than or equal to two thirds of the length of the power supply pins + 0.1 mm.

19. The portable terminal as claimed in claim 12, wherein the communication module also comprising:

- a printed circuit board (PCB);
- wherein, the printed circuit board is provided with an electronic components layout area, and a shield covering the electronic components layout area.

20. The portable terminal as claimed in claim 12, wherein the communication module also comprises a power element or a structural element, the power element or the structural element is arranged in the control system, and is connected to the printed circuit board (PCB) of the communication module through the NGFF interface.

J1    30    20

Power supply end    Charge protection unit    Switch unit    NGFF Inter-face    10

40    Delay unit

Figure 1

60

50

10    104 103 103 103 103 104    102 101    A
104 104

Figure 2

Figure 3

Figure 4

Figure 5

# INTERNATIONAL SEARCH REPORT

| International application No. |
| --- |
| **PCT/CN2013/081637** |

**A. CLASSIFICATION OF SUBJECT MATTER**

See the extra sheet

According to International Patent Classification (IPC) or to both national classification and IPC

**B. FIELDS SEARCHED**

Minimum documentation searched (classification system followed by classification symbols)

IPC: H04W; H04B; G06F; H02H

Documentation searched other than minimum documentation to the extent that such documents are included in the fields searched

Electronic data base consulted during the international search (name of data base and, where practicable, search terms used)

CNKI, CNPAT, WPI, EPODOC: power supply, universal serial bus, foot, hot plug, 3G, 4G, power, USB, PIN, charg+, switch+, protect+, delay+

**C. DOCUMENTS CONSIDERED TO BE RELEVANT**

| Category* | Citation of document, with indication, where appropriate, of the relevant passages | Relevant to claim No. |
| --- | --- | --- |
| X | CN 101969192 A (HUIZHOU TCL MOBILE COMMUNICATION CO., LTD.), 09 February 2011 (09.02.2011), description, paragraphs [0016]-[0030], and figures 1 and 2 | 1-20 |
| A | CN 103064489 A (HUAWEI DEVICE CO., LTD.), 24 April 2013 (24.04.2013), the whole document | 1-20 |
| A | CN 102681963 A (KONKA GROUP CO., LTD.), 19 September 2012 (19.09.2012), the whole document | 1-20 |
| A | US 2008133802 A1 (NIKON CORPORATION), 05 June 2008 (05.06.2008), the whole document | 1-20 |

☐ Further documents are listed in the continuation of Box C. ☒ See patent family annex.

| | |
| --- | --- |
| \*    Special categories of cited documents: | "T"  later document published after the international filing date or priority date and not in conflict with the application but cited to understand the principle or theory underlying the invention |
| "A"  document defining the general state of the art which is not considered to be of particular relevance | |
| "E"  earlier application or patent but published on or after the international filing date | "X"  document of particular relevance; the claimed invention cannot be considered novel or cannot be considered to involve an inventive step when the document is taken alone |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&"  document member of the same patent family |

| Date of the actual completion of the international search | Date of mailing of the international search report |
| --- | --- |
| 11 March 2014 (11.03.2014) | **27 March 2014 (27.03.2014)** |

| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer  **LI, Xiaoli**  Telephone No.: (86-10) **62414494** |
| --- | --- |

Form PCT/ISA/210 (second sheet) (July 2009)

## INTERNATIONAL SEARCH REPORT
### Information on patent family members

International application No.

**PCT/CN2013/081637**

| Patent Documents referred in the Report | Publication Date | Patent Family | Publication Date |
|---|---|---|---|
| CN 101969192 A | 09.02.2011 | None | |
| CN 103064489 A | 24.04.2013 | EP 2584471 A1 | 24.04.2013 |
| | | US 2013103966 A1 | 25.04.2013 |
| | | WO 2013056683 A1 | 25.04.2013 |
| | | JP 2013140562 A | 18.07.2013 |
| CN 102681963 A | 19.09.2012 | None | |
| US 2008133802 A1 | 05.06.2008 | JP 2008140311A | 19.06.2008 |

Form PCT/ISA/210 (patent family annex) (July 2009)

EP 3 016 471 A1

# INTERNATIONAL SEARCH REPORT

International application No.

**PCT/CN2013/081637**

**CONTINUATION: A. CLASSIFICATION OF SUBJECT MATTER**

H04W 88/02 (2009.01) i

H04B 1/40 (2006.01) i

G06F 1/18 (2006.01) i

G06F 13/14 (2006.01) i

Form PCT/ISA/210 (extra sheet) (July 2009)

18